# EUROPEAN PATENT APPLICATION

(11) **EP 4 768 945 A1**
(43) Date of publication of application: **01.07.2026**
(21) Application number: 25852285.3
(22) Date of filing: 07.08.2025
(51) Int. Cl.: G01R 31/382, G01R 19/165, G01R 19/10, G01R 19/30, H01M 10/48

(54) **APPARATUS AND METHOD FOR MANAGING BATTERY**

(30) Priority: 07.08.2024 KR 20240105530
(71) Applicant: LG Energy Solution, Ltd., Seoul 07335 (KR)
(72) Inventor: RYU, Jong-Hun, Daejeon 34122 (KR); SUN, Kyung-Eun, Daejeon 34122 (KR); BAE, Yoon-Jung, Daejeon 34122 (KR)
(74) Representative: Goddar, Heinz J.
(86) International application number: PCT/KR2025/011906
(87) International publication number: WO 2026/035061

(57) **Abstract**

The battery management apparatus according to an embodiment of the present disclosure includes a profile obtaining unit configured to obtain a differential profile representing a corresponding relationship between a voltage and a differential capacity of a battery; and a control unit configured to determine a feature point included in a preset reference voltage section of the differential profile and determine a state of the battery based on the determination result of the feature point.

## Description

### TECHNICAL FIELD

This application is based on and claims priority from Korean Patent Application No. 10-2024-0105530, filed on August 7, 2024, with the Korean Intellectual Property Office, the disclosure of which is incorporated herein in its entirety by reference.

The present disclosure relates to a battery management apparatus and method, and more specifically, to a battery management apparatus and method for determining a state of a battery.

### BACKGROUND ART

Recently, as the demand for portable electronic products such as laptops, video cameras, and mobile phones has increased rapidly and the development of electric vehicles, energy storage batteries, robots, and satellites has become full-fledged, research on highperformance batteries capable of repeated charging and discharging is actively being conducted.

Currently commercialized batteries include nickel cadmium batteries, nickel hydrogen batteries, nickel zinc batteries, and lithium batteries. Among these, lithium batteries are receiving attention due to their advantages such as the fact that they have almost no memory effect compared to nickel-based batteries, are free to charge and discharge, have a very low self-discharge rate, and have high energy density.

Although much research is being conducted on these batteries in terms of high capacity and high density, improving lifespan and safety is also important. In order to improve battery safety, technology that accurately determines the current state of the battery is required. In particular, as batteries increasingly incorporate not just a single active material but a mixture of multiple active materials, accurately determining the state of the battery is becoming more important.

### DISCLOSURE

### Technical Problem

The present disclosure is designed to solve the problems of the related art, and therefore the present disclosure is directed to providing a battery management apparatus and method capable of more accurately determining a state of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure may comprise: a profile obtaining unit configured to obtain a differential profile representing a corresponding relationship between a voltage and a differential capacity of a battery; and a control unit configured to determine a feature point included in a preset reference voltage section of the differential profile and determine a state of the battery based on the determination result of the feature point.

The control unit may be configured to detect a peak and an inflection point in the reference voltage section of the differential profile and determine the detected peak and the detected inflection point as the feature point.

The control unit may be configured to determine a target voltage section higher than or equal to a voltage of the peak among the reference voltage section and detect the inflection point in the target voltage section.

The control unit may be configured to determine the battery as a first battery containing a first active material or a second battery containing a second active material when only the peak is detected as the feature point.

The control unit may be configured to classify the reference voltage section into a first reference voltage section and a second reference voltage section.

The control unit may be configured to determine the battery as the first battery when the detected peak is included in the first reference voltage section.

The control unit may be configured to determine the battery as the second battery when the detected peak is included in the second reference voltage section.

The control unit may be configured to determine the battery as a third battery containing a first active material and a second active material when the peak and the inflection point are detected as the feature point.

The control unit may be configured to calculate a differential capacity ratio of the peak and the inflection point, and calculate a mixture ratio of the first active material and the second active material included in the third battery based on the calculated differential capacity ratio.

The control unit may be configured to set an upper limit voltage for the battery based on the determination result of the feature point.

The control unit may be configured to set the upper limit voltage as a voltage value preset to correspond to a type of the battery when there is one determined feature point.

The control unit may be configured to calculate a differential capacity ratio between a plurality of feature points when there are two determined feature points, and set the upper limit voltage by adding the differential capacity ratio to voltage values preset to correspond to a type of the battery with one corresponding feature point.

A battery pack according to another aspect of the present disclosure may comprise the battery management apparatus according to an aspect of the present disclosure.

A battery management method according to still another aspect of the present disclosure may comprise: a profile obtaining step of obtaining a differential profile representing a corresponding relationship between a voltage and a differential capacity of a battery; a feature point determining step of determining a feature point included in a preset reference voltage section of the differential profile; and a battery state determining step of determining a state of the battery based on the determination result of the feature points.

A computer-readable storage medium according to still another aspect of the present disclosure may store a computer program for executing a battery management method that includes: a profile obtaining step of obtaining a differential profile representing a corresponding relationship between a voltage and a differential capacity of a battery; a feature point determining step of determining a feature point included in a preset reference voltage section of the differential profile; and a battery state determining step of determining a state of the battery based on the determination result of the feature points.

### Advantageous Effects

According to one aspect of the present disclosure, the battery management apparatus has the advantage of being able to effectively detect the composition of the active material included in the battery as state information about the battery based on the differential profile of the battery.

In addition, the battery management apparatus has the advantage of preventing the battery from being overcharged by setting an upper limit voltage optimized for the battery based on the composition of the active material of the battery, thereby increasing the lifespan of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically of a battery management apparatus according to an embodiment of the present disclosure.
FIG. 2 is a schematic drawing of a battery profile according to an embodiment of the present disclosure.
FIG. 3 to FIG. 7 are schematic drawings of a differential profile according to an embodiment of the present disclosure.
FIG. 8 is a schematic drawing of a battery pack according to another embodiment of the present disclosure.
FIG. 9 is a diagram schematically of a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

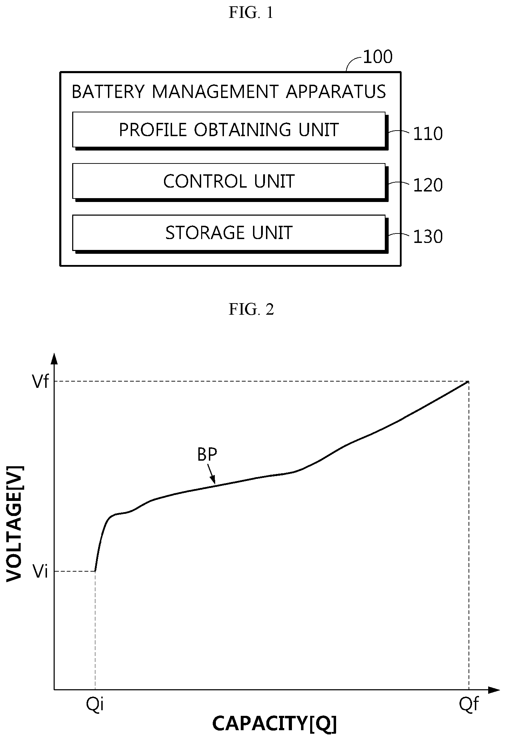

FIG. 1 is a diagram schematically showing a battery management apparatus 100 according to an embodiment of the present disclosure.

Referring to FIG. 1, the battery management apparatus 100 may include a measuring unit 110 and a control unit 120.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a differential profile representing a corresponding relationship between the voltage and differential capacity of the battery.

For example, a battery profile BP is a profile that represents the corresponding relationship between voltage (V) and capacity (Q) when the SOC of the battery is charged from the preset charge start SOC or 0% to the preset charge end SOC or 100%. As another example, a battery profile BP may represent the corresponding relationship between voltage (V) and capacity (Q) when the SOC of the battery is discharged from the preset discharge start SOC or 100% to the preset discharge end SOC or 0%.

FIG. 2 is a schematic drawing of a battery profile BP according to an embodiment of the present disclosure. In the embodiment of FIG. 2, the battery profile BP may be expressed as an X-Y graph in which the X-axis is set to capacity (Q) and the Y-axis is set to voltage (V). However, it should be noted that the battery profile BP of FIG. 2 is expressed in the form of a graph only for the convenience of explanation, and there is no limitation on the format in which the battery profile BP is expressed as long as a corresponding relationship between the capacity and voltage of the battery is shown.

For example, there is no specific limitation on the C-rate during charging or discharging for generating a battery profile BP. However, preferably, the battery should be charged or discharged at a low rate to obtain a more accurate battery profile BP and differential profile. For example, the battery profile BP may be generated during the process of charging or discharging the battery at 0.05 C.

Then, if the battery profile BP is differentiated with respect to voltage, a differential profile representing the corresponding relationship between differential capacity (dQ/dV) and voltage (V) may be generated. Here, differential capacity refers to the value obtained by differentiating capacity with respect to voltage. In other words, the differential profile may be said to be a profile obtained by differentiating the battery profile BP with respect to voltage.

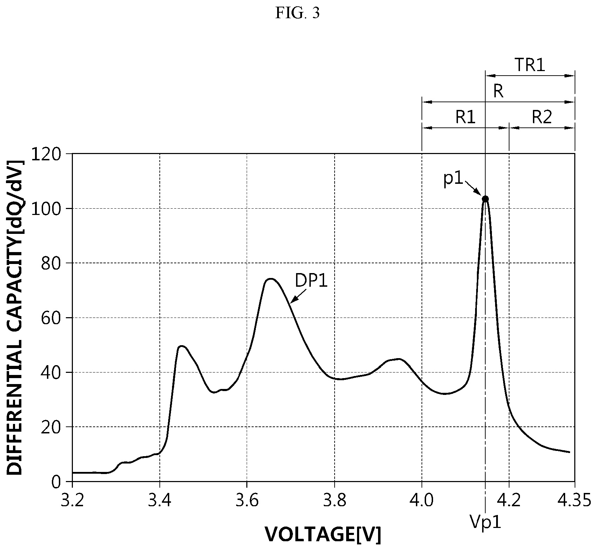

FIG. 3 to FIG. 7 are schematic drawings of a differential profile according to an embodiment of the present disclosure. In the embodiment of FIGS. 3 to 7, the differential profile may be represented as an X-Y graph in which the X-axis is set to voltage (V) and the Y-axis is set to differential capacity (dQ). Note that, as with the battery profile BP, there is no limitation on the format in which the battery profile BP may be represented as long as a corresponding relationship between the differential capacity and voltage of the battery is shown.

For example, the profile obtaining unit 110 may directly receive the differential profile of the battery from the outside. That is, the profile obtaining unit 110 may obtain the differential profile by being connected to the outside via wire and/or wirelessly and receiving the differential profile.

As another example, the profile obtaining unit 110 may directly receive the battery profile BP of the battery from the outside. Then, the profile obtaining unit 110 may generate a differential profile by differentiating the battery profile BP with respect to the voltage. That is, the profile obtaining unit 110 may obtain a differential profile by receiving the battery profile BP through a wired and/or wireless connection to the outside, and directly generating a differential profile from the battery profile BP.

As still another example, the profile obtaining unit 110 may receive battery information about the voltage and capacity of the battery. Then, the profile obtaining unit 110 may generate a battery profile BP based on the received battery information, and may generate a differential profile based on the generated battery profile BP. In other words, the profile obtaining unit 110 may obtain a differential profile by directly generating the differential profile based on the battery information.

The profile obtaining unit 110 may be connected to the control unit 120 so as to be able to communicate with it. For example, the profile obtaining unit 110 may be connected to the control unit 120 by wire and/or wirelessly. The profile obtaining unit may transmit the obtained differential profile to the control unit 120.

The control unit 120 may be configured to determine a feature point included in a preset reference voltage section R of the differential profile.

Specifically, the reference voltage section R may correspond to a portion of the entire voltage section of the differential profile. And, the state of the battery may be determined by the feature point included in the reference voltage section R. Accordingly, the control unit 120 may determine the feature point for the reference voltage section R among the voltage sections of the differential profile.

More specifically, the control unit 120 may be configured to detect a peak and an inflection point in the reference voltage section R of the differential profile.

Here, the peak represents the maximum point (a point with an upward convex shape) included in the differential profile. In other words, the rate of change of differential capacity with respect to voltage at the peak is 0, and the rate of change of differential capacity with respect to voltage may change from positive to negative based on the peak. For example, the control unit 120 may detect the peak corresponding to the maximum point in the reference voltage section R of the differential profile.

And, the inflection point represents a point where the direction of the bending changes in the differential profile. Specifically, the inflection point of the differential profile (V-dQ/dV profile) represents a peak (e.g., maximum point) included in the second-order differential profile (V-d(dQ)dV profile) obtained by differentiating the differential profile with respect to voltage. For example, the control unit 120 may detect a peak corresponding to the maximum point in the reference voltage section R of the second-order differential profile of the differential profile, and detect the inflection point of the differential profile based on the detected peak.

The control unit 120 may be configured to determine the detected peak and the detected inflection point as feature points.

Specifically, if a peak is detected in the reference voltage section R of the differential profile, the control unit 120 may determine the detected peak as a feature point. Similarly, if an inflection point is detected in the reference voltage section R of the differential profile, the control unit 120 may determine the detected inflection point as a feature point. That is, the feature point may include both the detected peak and the detected inflection point.

For example, if both a peak and an inflection point are detected in the reference voltage section R of the differential profile, the control unit 120 may determine both the detected peak and inflection point as feature points.

As another example, if a peak is detected in the reference voltage section R of the differential profile and an inflection point is not detected, the control unit 120 may determine the detected peak as a feature point.

As still another example, if an inflection point is detected in the reference voltage section R of the differential profile and a peak is not detected, the control unit 120 may not determine a feature point. Preferably, if a peak is not detected, the control unit 120 may not determine a feature point even if an inflection point is detected.

As still another example, if both the peak and the inflection point are not detected in the reference voltage section R of the differential profile, the control unit 120 may not determine the feature point.

The control unit 120 may be configured to determine the state of the battery based on the determination result of the feature point.

Specifically, the control unit 120 may determine the state of the battery by determining the type of active material included in the battery based on the determination result of the feature point. Preferably, the control unit 120 may determine whether the battery is a battery including a single active material or a battery including a mixed active material in which a plurality of active materials are mixed. For example, the control unit 120 may determine the state of the battery as a battery containing a first active material, a battery containing a second active material, or a battery containing both a first active material and a second active material.

Specifically, the first active material and the second active material may be positive electrode active materials. Here, the positive electrode active material includes nickel (Ni), cobalt (Co), and manganese (Mn), and the first active material and the second active material may be distinguished based on the nickel content.

For example, the first active material has a nickel content of 80% or more of the positive electrode active material, and a battery containing the first active material includes an NCM811 (Ni:Co:Mn = 8:1:1) battery.

As another example, the second active material has a nickel content of 70% or less of the positive electrode active material, and the battery containing the second active material includes an NCM712 (Ni:Co:Mn = 7:1:2) battery, an NCM721 (Ni:Co:Mn = 7:2:1) battery, an NCM622 (Ni:Co:Mn = 6:2:2) battery, an NCM523 (Ni:Co:Mn = 5:2:3) battery, and an NCM532 (Ni:Co:Mn = 5:3:2) battery.

That is, the battery management apparatus 100 has the advantage of being able to non-destructively detect the composition of the active material included in the battery as state information about the battery based on the differential profile of the battery.

Meanwhile, the profile obtaining unit 110 and the control unit 120 provided in the battery management apparatus 100 may selectively include processors known in the art, application-specific integrated circuits (ASICs), other chipsets, logic circuits, registers, communication modems, data processing devices, and the like to execute various control logic performed in the present disclosure. Also, when the control logic is implemented in software, the profile obtaining unit 110 and the control unit 120 may be implemented as a set of program modules. At this time, the program module may be stored in a memory and executed by the profile obtaining unit 110 and the control unit 120. The memory may be located inside or out of the profile obtaining unit 110 and the control unit 120 and may be connected to the profile obtaining unit 110 and the control unit 120 by various well-known means.

In addition, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its type as long as it is a known information storage means that can record, erase, update and read data. As an example, the information storage means may include RAM, flash memory, ROM, EEPROM, registers, and the like. In addition, the storage unit 130 may store program codes in which processes executable by each component of the battery management apparatus 100 are defined.

Hereinafter, with reference to FIGS. 3 to 7, an embodiment in which the control unit 120 determines a peak and an inflection point in a differential profile is specifically described. Here, the first to fifth differential profiles DP1, DP2, DP3, DP4, DP5 are differential profiles for different batteries.

Preferably, the control unit 120 may be configured to determine a target voltage section corresponding to a voltage or higher of the peak of the reference voltage section R.

Specifically, the control unit 120 may first detect a peak in the reference voltage section R of the differential profile. When a peak is detected, the control unit 120 may determine a voltage section higher than or equal to the voltage of the peak among the reference voltage section R as the target voltage section.

Here, the reference voltage section R is a voltage section preset to include both the peak and the inflection point, and is commonly applied to a battery (or differential profile) to be diagnosed. That is, even if the differential profiles are for different batteries, the reference voltage section R is applied as a common voltage section. The reference voltage section R may be set as a voltage section from the preset start voltage (Va) to the preset upper limit voltage (Vb). For example, the reference voltage section R may be preset to 4.0 [V] to 4.35 [V].

The target voltage section may be determined as a voltage section from the peak voltage to the preset upper limit voltage. For example, assuming that the peak voltage is Vp [V] and the preset upper limit voltage is 4.35 [V], the target voltage section may be determined as Vp [V] to 4.35 [V].

In addition, the control unit 120 may be configured to detect an inflection point in the target voltage section.

Specifically, the control unit 120 may detect the inflection point only for the area included in the target voltage section among the differential profile.

In the embodiment of FIG. 3, the control unit 120 may detect the first peak p1 in the reference voltage section R of the first differential profile DP1. Then, the control unit 120 may determine a voltage section higher than or equal to the voltage of the first peak p1 as the target voltage section. That is, the first target voltage section TR1 of the first differential profile DP1 may be determined as a section higher than or equal to the voltage of the first peak p1 and lower than or equal to 4.35 [V]. Then, since the first target voltage section TR1 does not include an inflection point, the control unit 120 may not detect the inflection point in the first target voltage section TR1. Therefore, the control unit 120 may determine the first peak p1 as a feature point for the battery.

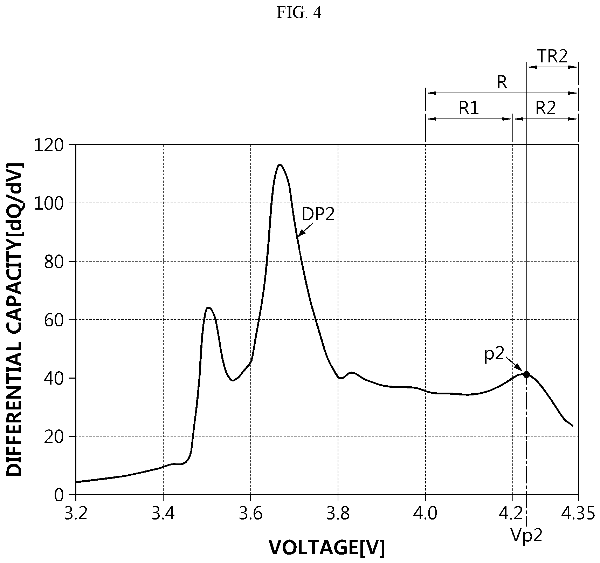

In the embodiment of FIG. 4, the control unit 120 may detect the second peak p2 in the reference voltage section R of the second differential profile DP2. Then, the control unit 120 may determine a voltage section higher than or equal to the voltage of the second peak p2 as the target voltage section. That is, the second target voltage section TR2 of the second differential profile DP2 may be determined as a section higher than or equal to the voltage of the second peak p2 and lower than or equal to 4.35 [V]. Then, since the second target voltage section TR2 does not include an inflection point, the control unit 120 may not detect the inflection point in the second target voltage section TR2. Therefore, the control unit 120 may determine the second peak p2 as a feature point for the battery.

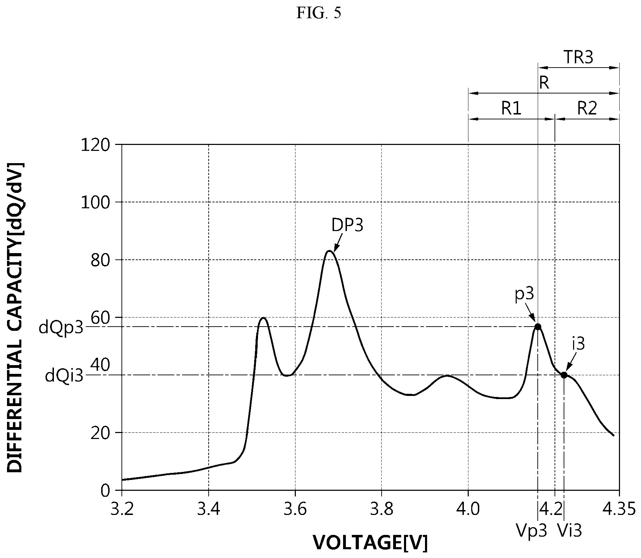

In the embodiment of FIG. 5, the control unit 120 may detect the third peak p3 in the reference voltage section R of the third differential profile DP3. In addition, the control unit 120 may determine a voltage section higher than or equal to the voltage of the third peak p3 as the target voltage section. That is, the third target voltage section TR3 of the third differential profile DP3 may be determined as a section higher than or equal to the voltage of the third peak p3 and lower than or equal to 4.35 [V]. Here, since the third target voltage section TR3 includes an inflection point, the control unit 120 may detect the third inflection point i3 in the third target voltage section TR3. Therefore, the control unit 120 may determine the third peak p3 and the third inflection point i3 as feature points for the battery.

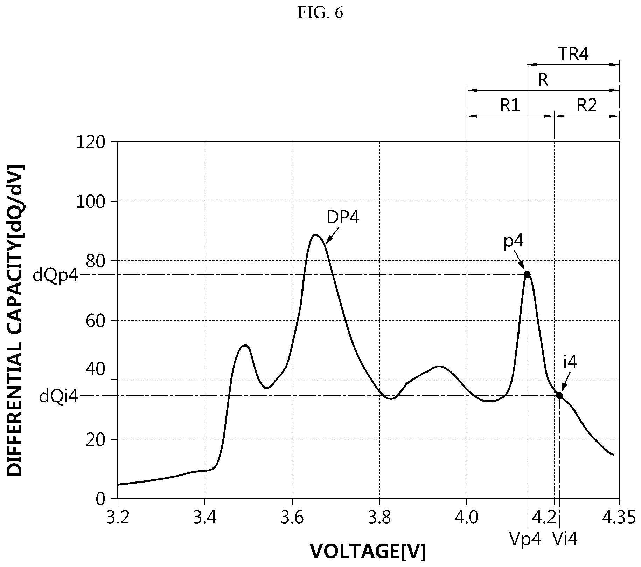

In the embodiment of FIG. 6, the control unit 120 may detect the fourth peak p4 in the reference voltage section R of the fourth differential profile DP4. In addition, the control unit 120 may determine a voltage section higher than or equal to the voltage of the fourth peak p4 as the target voltage section. That is, the fourth target voltage section TR4 of the fourth differential profile DP4 may be determined as a section higher than or equal to the voltage of the fourth peak p4 and lower than or equal to 4.35 [V]. Here, since the fourth target voltage section TR4 includes an inflection point, the control unit 120 may detect the fourth inflection point i4 in the fourth target voltage section TR4. Therefore, the control unit 120 may determine the fourth peak p4 and the fourth inflection point i4 as feature points for the battery.

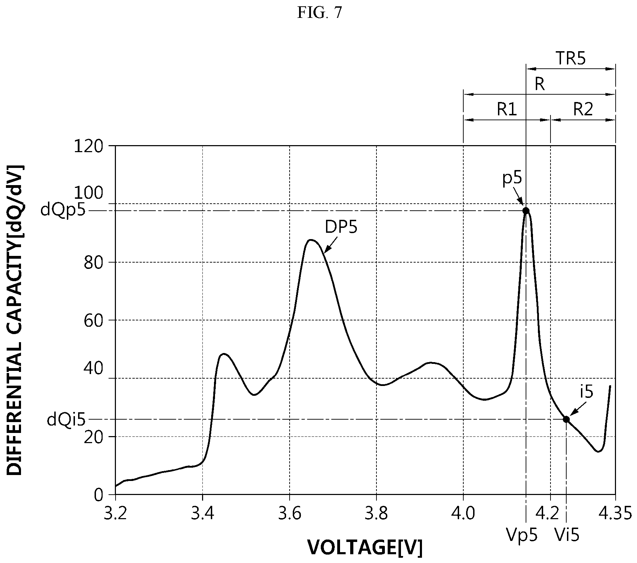

In the embodiment of FIG. 7, the control unit 120 may detect the fifth peak p5 in the reference voltage section R of the fifth differential profile DP5. In addition, the control unit 120 may determine a voltage section higher than or equal to the voltage of the fifth peak p5 as a target voltage section. That is, the fifth target voltage section TR5 of the fifth differential profile DP5 may be determined as a section higher than or equal to the voltage of the fifth peak p5 and lower than or equal to 4.35 [V]. Here, since the fifth target voltage section TR5 includes an inflection point, the control unit 120 may detect the fifth inflection point i5 in the fifth target voltage section TR5. Therefore, the control unit 120 may determine the fifth peak p5 and the fifth inflection point i5 as feature points for the battery.

In the above embodiments, the reference voltage section R is the same as the voltage section of 4.0[V] to 4.35[V], but the first to fifth target voltage sections TR5 may be determined to be the same or different from each other depending on the voltages (Vp1, Vp2, Vp3, Vp4, Vp5) of the first to fifth peaks p1, p2, p3, p4, p5.

Below, an embodiment in which the control unit 120 determines the state of a battery based on the determined feature points is specifically described.

In one embodiment, the control unit 120 may be configured to determine the battery as a first battery containing the first active material or a second battery containing the second active material when only a peak is detected as a feature point.

Specifically, if a peak is detected in the reference voltage section R but no inflection point is detected in the target voltage section, the feature point may include only the peak. In this case, the control unit 120 may determine that the battery contains a single active material. Accordingly, the control unit 120 may determine the battery as a first battery containing the first active material or a second battery containing the second active material.

Here, the first battery and the second battery may be distinguished based on the voltage of the corresponding peak. That is, the battery may be classified into the first battery or the second battery depending on the magnitude of the voltage of the peak included in the reference voltage section R.

More specifically, the control unit 120 may be configured to classify the reference voltage section R into a first reference voltage section R1 and a second reference voltage section R2.

The control unit 120 may classify the reference voltage section R into the first reference voltage section R1 and the second reference voltage section R2 based on the preset reference voltage. Here, the reference voltage is a voltage set to classify the reference voltage section R into the first reference voltage section R1 and the second reference voltage section R2. In particular, the reference voltage is commonly applied to the battery (or differential profile) to be diagnosed. That is, even if the differential profiles are for different batteries, the reference voltage is applied as a common voltage value.

For example, assume that the reference voltage section R is a voltage section higher than or equal to the starting voltage (Va) and lower than or equal to the upper limit voltage (Vb), and that the reference voltage is Vr [V]. Here, the relationship Va [V] < Vr [V] < Vb [V] is established.

The control unit 120 may set the voltage section higher than or equal to Va [V] and lower than or equal to Vr [V] as the first reference voltage section R1, and the voltage section higher than or equal to Vr [V] and lower than or equal to Vb [V] as the second reference voltage section R2.

For example, the control unit 120 may be configured to determine the battery as a first battery if the detected peak is included in the first reference voltage section R1. As another example, the control unit 120 may be configured to determine the battery as a second battery if the detected peak is included in the second reference voltage section R2.

In the following, for the convenience of explanation, it is assumed that the reference voltage is preset to 4.2 [V]. That is, the control unit 120 may classify the reference voltage section (R, 4.0 [V] to 4.35 [V]) into a first reference voltage section (R1, 4.0 [V] to 4.2 [V]) and a second reference voltage section (R2, 4.2 [V] to 4.35 [V]) based on the reference voltage (4.2 [V]).

In the embodiment of FIG. 3, since the voltage of the first peak p1 is less than the reference voltage (4.2 [V]), the first peak p1 may be included in the first reference voltage section R1. Therefore, the control unit 120 may determine the battery as the first battery containing the first active material.

In the embodiment of FIG. 4, since the voltage of the second peak p2 is greater than the reference voltage (4.2 [V]), the second peak p2 may be included in the second reference voltage section R2. Therefore, the control unit 120 may determine the battery as the second battery containing the second active material.

In another embodiment, the control unit 120 may be configured to determine the battery as the third battery containing the first active material and the second active material when a peak and an inflection point are detected as feature points.

Specifically, when a peak is detected in the reference voltage section R and an inflection point is detected in the target voltage section, the control unit 120 may determine the battery as a third battery containing both the first active material and the second active material. Here, the third battery contains an active material that is a blend of the first active material and the second active material.

In the embodiment of FIG. 5, the reference voltage section R includes a third peak p3, and the third target voltage section TR3 includes a third inflection point i3. Here, the voltage of the third inflection point i3 is Vi3 [V]. Therefore, the control unit 120 may determine the battery according to the embodiment of FIG. 5 as the third battery.

In the embodiment of FIG. 6, the fourth peak p4 is included in the reference voltage section R, and the fourth inflection point i4 is included in the fourth target voltage section TR4. Here, the voltage of the fourth inflection point i4 is Vi4 [V]. Therefore, the control unit 120 may determine the battery according to the embodiment of FIG. 6 as the third battery.

In the embodiment of FIG. 7, the reference voltage section R includes a fifth peak p5, and the fifth target voltage section TR5 includes a fifth inflection point i5. Here, the voltage of the fifth inflection point i5 is Vi5 [V]. Therefore, the control unit 120 may determine the battery according to the embodiment of FIG. 7 as the third battery.

According to the battery management apparatus 100 according to an embodiment of the present disclosure, a type of battery of unknown composition may be distinguished or the composition of a manufactured battery may be verified in a non-destructive manner by analyzing a differential profile.

Below, an embodiment in which control unit 120 calculates the mixture ratio of the first active material and the second active material included in the third battery is specifically described.

The control unit 120 may be configured to calculate a differential capacity ratio of the peak and the inflection point.

Specifically, the control unit 120 may calculate the differential capacity ratio by calculating the ratio between the differential capacity of the peak and the inflection point. For example, the control unit 120 may calculate the differential capacity ratio by calculating the ratio of the differential capacity of the inflection point to the differential capacity of the peak.

Assume that the differential capacity of the peak is dQp and the differential capacity of the inflection point is dQi. Preferably, since the differential capacity of the peak is greater than the differential capacity of the inflection point, the control unit 120 may calculate the differential capacity ratio by calculating the formula "dQi ÷ dQp". Here, the inflection point refers to a point where the curve of the differential profile changes from concave (a shape that is convex upward) to convex (a shape that is convex downward). In the reference voltage section R, the point that is convex upward is detected as a peak, and since the voltage of the inflection point is greater than the voltage of the peak, the differential capacity of the inflection point is less than the differential capacity of the peak.

In the embodiment of FIG. 5, the differential capacity of the third peak p3 is dQp3, and the differential capacity of the third inflection point i3 is dQi3. The control unit 120 may calculate the formula "dQi3 ÷ dQp3" to derive the differential capacity ratio for the battery.

In the embodiment of FIG. 6, the differential capacity of the fourth peak p4 is dQp4, and the differential capacity of the fourth inflection point i4 is dQi4. The control unit 120 may calculate the formula "dQi4 ÷ dQp4" to derive the differential capacity ratio for the battery.

In the embodiment of FIG. 7, the differential capacity of the fifth peak p5 is dQp5, and the differential capacity of the fifth inflection point i5 is dQi5. The control unit 120 may calculate the formula "dQi5 ÷ dQp5" to derive the differential capacity ratio for the battery.

The control unit 120 may be configured to calculate the mixture ratio of the first active material and the second active material included in the third battery based on the calculated differential capacity ratio.

Specifically, the control unit 120 may calculate the differential capacity ratio as the ratio of the first active material to the second active material. For example, if the differential capacity ratio is 50%, the mixture ratio of the first active material to the second active material is 5:5. As another example, if the differential capacity ratio is 60%, the mixture ratio of the first active material to the second active material is 6:4.

The battery management apparatus 100 may calculate the mixture ratio of the first active material and the second active material included in the battery by calculating the differential capacity ratio of the peak and the inflection point. In other words, since the battery management apparatus 100 may non-destructively calculate the mixture ratio of a plurality of active materials by analyzing the differential profile, it has the advantage of being able to effectively confirm and verify the composition of the battery.

The control unit 120 may be configured to set an upper limit voltage for the battery based on the determination result of the feature point. Here, the upper limit voltage is a maximum voltage set to terminate charging of the battery, and is a voltage set to prevent accelerated degradation of the battery.

In one embodiment, the control unit 120 may be configured to set the upper limit voltage to a voltage value preset to correspond to the type of battery when there is one determined feature point.

Specifically, the case where there is one feature point means that the feature point only includes a peak. In this case, the battery is the first battery containing the first active material or the second battery containing the second active material. Therefore, the upper limit voltage of the battery may be set to an upper limit voltage preset for the type of active material included in the battery. For example, if the battery is a first battery, the control unit 120 may set the upper limit voltage of the battery to 4.25 [V]. As another example, if the battery is a second battery, the control unit 120 may set the upper limit voltage of the battery to 4.35 [V].

In another embodiment, when there are two determined feature points, the control unit 120 may be configured to calculate a differential capacity ratio between the plurality of feature points. In addition, the control unit 120 may be configured to set an upper limit voltage by adding the differential capacity ratio to voltage values preset to correspond to a type of battery having one corresponding feature point.

As previously explained, the differential capacity ratio for the peak and for inflection point may correspond to the mixture ratio of the first active material and the second active material included in the battery. Accordingly, the control unit 120 may set the upper limit voltage of the battery by adding the calculated differential capacity ratio to the voltage set for the first active material and the voltage set for the second active material.

Assume that the voltage set for the first active material is Vs [V], the voltage set for the second active material is V t[V], and the calculated differential capacity ratio is k%. Here, the relationship Vs [V] < Vt [V] is established. The control unit 120 may set the upper limit voltage of the battery by calculating the formula "Vt [V] - (Vt [V] - Vs [V]) × k%".

For example, assume that the voltage set for the first active material is 4.25 [V], the voltage set for the second active material is 4.35 [V], and the calculated differential capacity ratio is 60%. That is, the mixture ratio of the first active material and the second active material is 6:4. The control unit 120 may set the upper limit voltage of the battery to 4.29 [V] by calculating the formula "4.35 - (4.35 - 4.25) × 0.6". That is, as the mixture ratio of the first active material increases, the upper limit voltage may get closer to the voltage set for the first active material, and as the mixture ratio of the second active material increases, the upper limit voltage may get closer to the voltage set for the second active material.

The battery management apparatus 100 may not only detect the composition of a battery, but also set an upper limit voltage optimized for the battery based on the composition of the battery. By setting an optimized upper limit voltage, the battery may be prevented from being overcharged, thereby extending its lifespan.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the components included in the conventional BMS. For example, the profile obtaining unit 110 and the control unit 120 of the battery management apparatus 100 may be implemented as components of the

BMS.

In addition, the battery management apparatus 100 according to the present disclosure may be provided in a battery pack. That is, the battery pack according to the present disclosure may include the above-described battery management apparatus 100 and one or more battery cells. In addition, the battery pack may further include electrical equipment (relays, fuses, etc.) and a case.

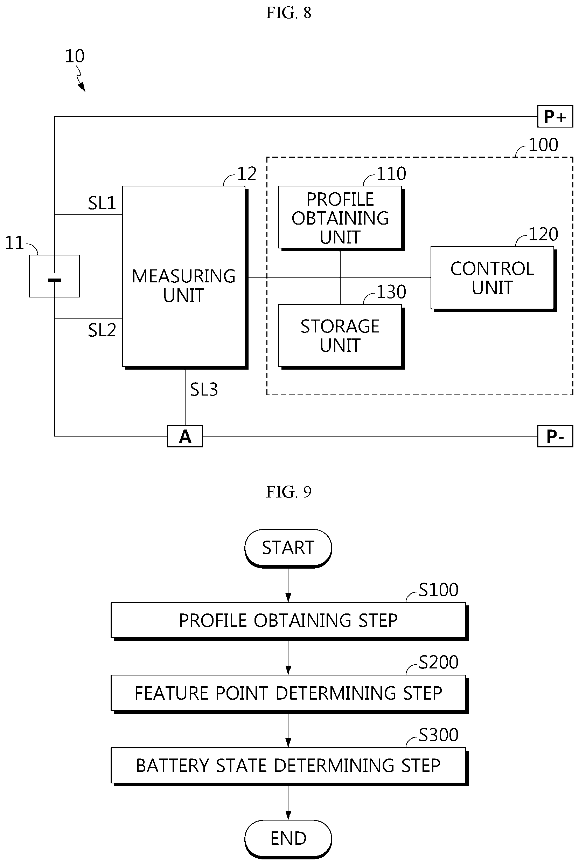

FIG. 8 is a schematic drawing of a battery pack 10 according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

For example, the profile obtaining unit 110 may receive battery information about the voltage and current of the battery from the measuring unit 12. Then, the profile obtaining unit 110 may generate a battery profile BP and a differential profile based on the battery information.

As another example, the profile obtaining unit 110 may receive a battery profile BP from the measuring unit 12. Then, the profile obtaining unit 110 may generate a differential profile based on the battery profile BP.

As still another example, the profile obtaining unit 110 may receive a differential profile from the measuring unit 12.

An external device may be connected to the positive electrode terminal P+ and the negative electrode terminal P- of the battery pack 10. For example, the external device may be a charging device or a load. In addition, the positive electrode terminal of the battery module 11, the positive electrode terminal P+ of the battery pack 10, the external device, the negative electrode terminal P- of the battery pack 10, and the negative electrode terminal of the battery module 11 may be electrically connected.

The battery pack according to an embodiment of the present disclosure may be included in a vehicle, such as an electric vehicle (EV) or a hybrid vehicle (HV). In addition, the battery pack may drive the vehicle by supplying power to a motor through an inverter provided in the vehicle. Here, the battery pack may include the battery management apparatus. That is, the vehicle may include the battery management apparatus 100. In this case, the battery management apparatus 100 may be an onboard device included in the vehicle.

FIG. 9 is a diagram schematically showing a battery management method according to still another embodiment of the present disclosure.

Referring to FIG. 9, the battery management method may include a profile obtaining step (S100), a feature point determining step (S200), and a battery state determining step (S300).

Preferably, each step of the battery management method may be performed by the battery management apparatus 100. Hereinafter, for convenience of explanation, contents overlapping with the previously described contents will be omitted or briefly described.

The profile obtaining step (S100) is a step of obtaining a differential profile representing a corresponding relationship between a voltage and a differential capacity of a battery, and may be performed by the profile obtaining unit 110.

For example, the profile obtaining unit 110 may directly receive the differential profile of the battery from the outside. That is, the profile obtaining unit 110 may obtain the differential profile by receiving the differential profile while being connected to the outside via wire and/or wirelessly.

As another example, the profile obtaining unit 110 may directly receive the battery profile BP of the battery from the outside. Then, the profile obtaining unit 110 may generate a differential profile by differentiating the battery profile BP with respect to the voltage. That is, the profile obtaining unit 110 may obtain a differential profile by receiving the battery profile BP through a wired and/or wireless connection to the outside, and directly generating a differential profile from the battery profile BP.

As still another example, the profile obtaining unit 110 may receive battery information about the voltage and capacity of the battery. Then, the profile obtaining unit 110 may generate a battery profile BP based on the received battery information, and may generate a differential profile based on the generated battery profile BP. In other words, the profile obtaining unit 110 may obtain a differential profile by directly generating the differential profile based on the battery information.

The feature point determining step (S200) is a step of determining a feature point included in a preset reference voltage section R of the differential profile, and may be performed by the control unit 120.

The control unit 120 may be configured to detect a peak and an inflection point in the reference voltage section R of the differential profile, and determine the detected peak and the detected inflection point as feature points.

Specifically, the control unit 120 may detect a peak in the reference voltage section R. Then, the control unit 120 may determine a target voltage section corresponding to a voltage higher than or equal to the peak in the reference voltage section R. Thereafter, the control unit 120 may be configured to detect an inflection point in the target voltage section.

The battery state determining step (S300) is a step of determining the state of the battery based on the determination result of the feature point, and may be performed by the control unit 120.

Specifically, the control unit 120 may determine the state of the battery by determining the type of active material included in the battery based on the determination result of the feature point.

In addition, the control unit 120 may detect the composition of the battery and set an upper limit voltage optimized for the battery based on the composition of the battery.

Another embodiment of the present disclosure may provide a computer-readable storage medium on which a program for performing the various embodiments described above on a computer is recorded.

The program may be implemented as hardware components, software components, and/or a combination of hardware components and software components. The program may be executed by any system capable of executing computer-readable instructions.

Software may include computer programs, codes, instructions, or a combination thereof, which may configure a processing device to perform a desired operation or may independently or collectively command a processing device.

The software may be implemented as a computer program including instructions stored on a computer-readable storage medium. Examples of the computer-readable storage medium include magnetic storage media (e.g., read-only memory (ROM), randomaccess memory (RAM), floppy disks, hard disks, etc.) and optical reading media (e.g., CD-ROM, DVD: Digital Versatile Disc). The computer-readable storage medium may be distributed across network-connected computer systems so that the computer-readable codes may be stored and executed in a distributed manner. The storage medium may be readable by a computer, stored in a memory, and executed by a processor.

A computer-readable storage medium may be provided in the form of a non-transitory storage medium. Here, the term 'non-transitory storage medium' simply means that it is a tangible device and does not contain signals (e.g., electromagnetic waves), and this term does not distinguish between cases where data is stored semi-permanently on the storage medium and cases where data is stored temporarily. For example, the 'non-transitory storage medium' may include a buffer in which data is temporarily stored.

Additionally, the program may be provided as part of a computer program product. The computer program product may be traded between sellers and buyers as a commodity.

A computer program product may include a software program, and a computer-readable storage medium storing the software program. For example, the computer program product may include a product in the form of a software program (e.g., a downloadable application) distributed electronically by a manufacturer of an electronic device or through an electronic market. For electronic distribution, at least a portion of the software program may be stored on a storage medium or temporarily generated. In this case, the storage medium may be a storage medium of a server of a manufacturer of an electronic device, a server of an electronic market, or a relay server that temporarily stores the software program.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
11: battery
12: measuring unit
100: battery management apparatus
110: profile obtaining unit
120: control unit
130: storage unit

## Claims

1. A battery management apparatus, comprising:
a profile obtaining unit configured to obtain a differential profile representing a corresponding relationship between a voltage and a differential capacity of a battery; and
a control unit configured to determine a feature point included in a preset reference voltage section of the differential profile and determine a state of the battery based on the determination result of the feature point.

2. The battery management apparatus according to claim 1,
wherein the control unit is configured to detect a peak and an inflection point in the reference voltage section of the differential profile and determine the detected peak and the detected inflection point as the feature point.

3. The battery management apparatus according to claim 2,
wherein the control unit is configured to determine a target voltage section higher than or equal to a voltage of the peak among the reference voltage section and detect the inflection point in the target voltage section.

4. The battery management apparatus according to claim 2,
wherein the control unit is configured to determine the battery as a first battery containing a first active material or a second battery containing a second active material when only the peak is detected as the feature point.

5. The battery management apparatus according to claim 4,
wherein the control unit is configured to:
classify the reference voltage section into a first reference voltage section and a second reference voltage section,
determine the battery as the first battery when the detected peak is included in the first reference voltage section, and
determine the battery as the second battery when the detected peak is included in the second reference voltage section.

6. The battery management apparatus according to claim 2,
wherein the control unit is configured to determine the battery as a third battery containing a first active material and a second active material when the peak and the inflection point are detected as the feature point.

7. The battery management apparatus according to claim 6,
wherein the control unit is configured to calculate a differential capacity ratio of the peak and the inflection point, and calculate a mixture ratio of the first active material and the second active material included in the third battery based on the calculated differential capacity ratio.

8. The battery management apparatus according to claim 1,
wherein the control unit is configured to set an upper limit voltage for the battery based on the determination result of the feature point.

9. The battery management apparatus according to claim 8,
wherein the control unit is configured to set the upper limit voltage as a voltage value preset to correspond to a type of the battery when there is one determined feature point.

10. The battery management apparatus according to claim 8,
wherein the control unit is configured to:
calculate a differential capacity ratio between a plurality of feature points when there are two determined feature points, and
set the upper limit voltage by adding the differential capacity ratio to voltage values preset to correspond to a type of the battery with one corresponding feature point.

11. A battery pack, comprising the battery management apparatus according to any one of claims 1 to 10.

12. A battery management method, comprising:
a profile obtaining step of obtaining a differential profile representing a corresponding relationship between a voltage and a differential capacity of a battery;
a feature point determining step of determining a feature point included in a preset reference voltage section of the differential profile; and
a battery state determining step of determining a state of the battery based on the determination result of the feature points.

13. A computer-readable storage medium storing a computer program for executing a battery management method that includes:
a profile obtaining step of obtaining a differential profile representing a corresponding relationship between a voltage and a differential capacity of a battery;
a feature point determining step of determining a feature point included in a preset reference voltage section of the differential profile; and
a battery state determining step of determining a state of the battery based on the determination result of the feature points.
